Europäisches Patentamt

European Patent Office

Office européen des brevets

(11) Veröffentlichungsnummer: **0 349 715 B1**

# EUROPÄISCHE PATENTSCHRIFT

(45) Veröffentlichungstag der Patentschrift: **05.01.94**

(21) Anmeldenummer: **89106224.2**

(22) Anmeldetag: **08.04.89**

(51) Int. Cl.5: **H03K 5/13**, H03K 5/135, H04J 3/04

(54) Verfahren und Schaltungsanordnung zur Erzeugung eines phasenverschobenen Taktsignales.

(30) Priorität: **06.07.88 DE 3822857**

(43) Veröffentlichungstag der Anmeldung:
**10.01.90 Patentblatt 90/02**

(45) Bekanntmachung des Hinweises auf die
Patenterteilung:
**05.01.94 Patentblatt 94/01**

(84) Benannte Vertragsstaaten:
**FR GB IT NL**

(56) Entgegenhaltungen:
**DE-A- 2 344 152**
**DE-A- 3 546 132**
**DE-A- 3 711 592**

**PATENT ABSTRACTS OF JAPAN vol. 6, no.**
**52 (E-100)(930) 07 April 1982, & JP-A-56**
**164625 (SONY K.K.) 17 Dezember 1981,**

**RADIO FERNSEHEN ELEKTRONIK. vol. 32, no.**
**3, März 1983, BERLIN DD Seiten 188 - 192; A.**
**Bogatz: "Phasenschieberschaltungen für**
**Rechtecksignale"**

**IEEE Journal of Lightwave Technology vol.**
**LT-2, no. 6, Dezember 1984, New York Seiten**

**926 - 932; P.A. Dawson et al.: "An undersea**
**Fiber-optic regenerator using an integral-**
**substrate package and flip-chip SAW moun-**
**ting"**

(73) Patentinhaber: **ANT Nachrichtentechnik GmbH**
**Gerberstrasse 33**
**D-71522 Backnang(DE)**

(72) Erfinder: **Rein, Hans-Martin, Prof. Dr.-Ing.**
**Ein Bäumchen 6**
**D-5810 Witten 3(DE)**

EP 0 349 715 B1

## Beschreibung

Die Erfindung bezieht sich auf ein Verfahren (Patentanspruch 1) bzw. eine Schaltungsanordnung (Patentspruch 5 bzw. 11) zur Erzeugung eines phasenverschobenen Taktsignales.

Phasenschieber der üblichen Art ermöglichen Phasenverschiebungen um Beträge im Bereich 0 bis etwa -120°, s. Aufsatz "An Undersea fiber Optic Regenerator Using an Integral Substrate Pakkage and Flip-Chip SAW Mounting" von Dawson and Rogerson, Journal of Lightwave Technology, Vol. LT-2, No. 6, Dec. 1984, S. 926 - 932.

Der Erfindung lag die Aufgabe zugrunde, ein Verfahren bzw. eine Schaltungsanordnung anzugeben, welche in der Lage sind, Phasenverschiebungen im Bereich zwischen 0 und $-\pi$ kontinuierlich in einem weiten Frequenzbereich zu ermöglichen, ohne daß ein Abgleich der Schaltung erforderlich ist, der jeweils bei üblichen Phasenschiebern - auch bei der oben angegebenen Referenz - an die Signalfrequenz angepaßte werden muß.
Das Verfahren bzw. die Schaltungsanordnung gestattet eine beliebige kontinuierliche Phasenverschiebung im Bereich zwischen 0 und $-\pi$, wobei der Aufwand hierfür relativ gering ist. Dabei ist weder ein interner Abgleich, noch sind externe Elemente, beispielsweise Laufzeitleitungen, erforderlich, die jeweils an die Signalfrequenz angepaßt werden müßten, beispielsweise durch entsprechende Einstellung der Länge einer Laufzeitleitung. Vielmehr erfolgt die Phasenverschiebung unabhängig von der Signalfrequenz. Damit ergibt sich als weiterer Vorteil gegenüber üblichen Phasenschiebern die einfache monolithische Integrierbarkeit der Schaltung, die zu einer erheblichen Kostenverringerung führt.

Der vorliegenden Erfindung lag weiterhin die Aufgabe zugrunde, die Kontinuität der Phasenverschiebung auch bei Eingangssignalen hoher Amplitude (also bei bestehender Gefahr einer Übersteuerung der Eingangsstufen der eingesetzten Phasenschieber) oder bei rechteckförmigen Signalen zu erhalten, ohne daß der zusätzliche Aufwand hier zu groß wird. Außerdem soll der Vorteil der monolithischen Integrierbarkeit erhalten bleiben.

Die Lösung dieser Aufgabe erfolgt durch die Merkmale des Patentanspruches 1, 5 bzw. 11.
Vorteilhafte Ausgestaltungen ergeben sich durch die abhängigen Ansprüche.

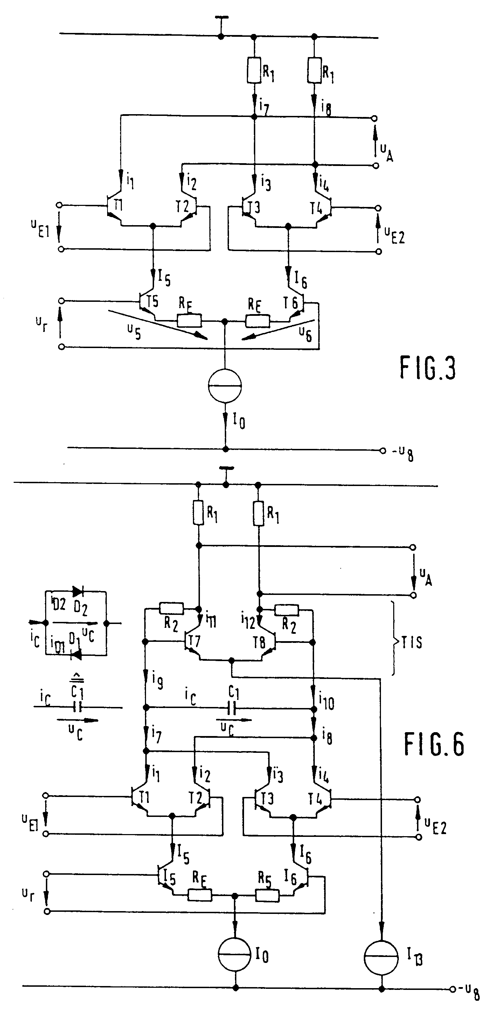

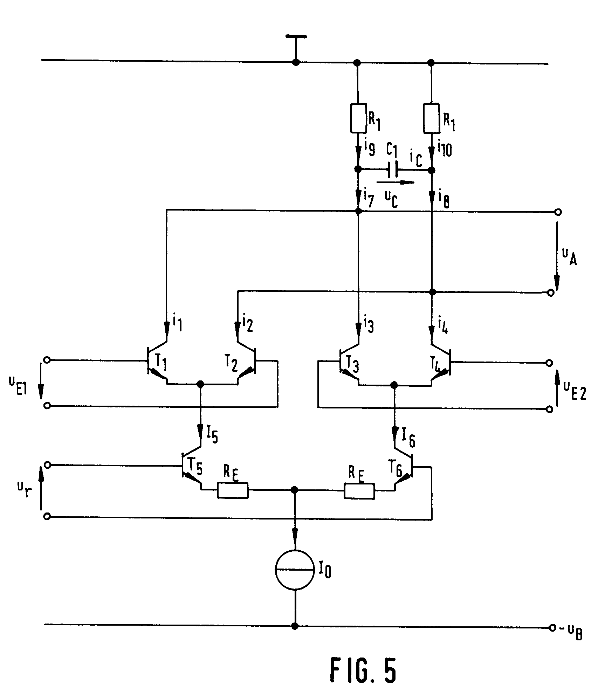

Der Erfindung liegt die Überlegung zugrunde, daß bei Einsatz von Phasenschiebern der Schaltungsanordnung gemäß Fig. 3 bzw. nach Dawson und Rogerson, (s. obiger Aufsatz, S. 929 Fig. 5) ungünstige Ausgangssignale auftreten können, wenn sie mit rechteckförmigen Eingangssignalen oder Eingangssignalen hoher Amplitude betrieben werden.

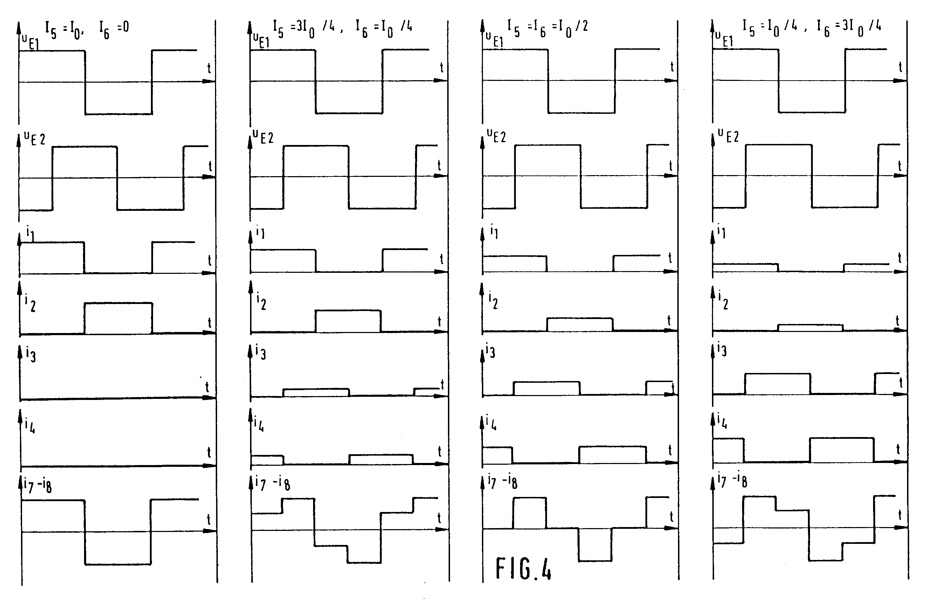

Diese Effekte treten vorwiegend weit unterhalb der oberen Frequenzgrenze der Schaltung auf und können z.B. zu treppenförmigen Ausgangssignalen führen. Dadurch werden die Nulldurchgänge der Ausgangsspannung nicht in ausreichendem Maße stetig mit der Steuerspannung verschoben, wobei sogar im Extremfall die Steigung in Nullgang verschwinden kann, wenn die Steuerspannung zu 0 wird. Diese Effekte sind durch die über der aufgetragenen Eingangs- und Ausgangssignalen der Phasenschieberschaltung in Fig. 4 veranschaulicht. Sie stören z.B. dann, wenn das Signal am Ausgang des Phasenschiebers regeneriert und/oder frequenzverdoppelt werden soll. Die Effekte sind in der vorgeschlagenen Schaltungsanordnung (unter Erhaltung der monolithischen Integrierbarkeit) beseitigbar durch je einen Tiefpaß am Ausgang der beiden Phasenschieber. Der Tiefpaß dämpft dabei die Amplitude der Oberwellen in Bezug auf die Grundfrequenz (also der Frequenz des frequenzhalbierten Signals an den Ausgängen des vorangehenden Master-Slave-Flip-Flops M. S).

Das sich an die ausgangsseitig hinter die Phasenschieber $\tau1$, $\tau2$ eingefügten Tiefpässe anschließende EXOR-Gatter, s. Fig. 1a regeneriert das Signal bei gleichzeitiger Frequenzverdopplung. Auch Tiefpässe an den beiden Signaleingängen der Phasenschieber sind möglich, allerdings ist in diesem Fall bei großer Aussteuerung eine Seriengegenkopplung, beispielsweise durch Widerstände in Reihe zu den Emittern, zur Linearisierung erforderlich, um die Übersteuerung der Phasenschieber zu vermeiden.

Im einfachsten Fall kann man die Tiefpaßfunktion durch eine Kapazität parallel zum Ausgang der Phasenschieber realisieren, s. Fig. 5. (Wird die Schaltung in der Nähe ihrer oberen Frequenzgrenze betrieben, so können wegen der parasitären Kapazitäten der Transistoren keine rechteckförmigen Impulse auftreten, so daß diese Maßnahme nicht erforderlich ist).

Eine weitere Verbesserung der Phasenverschiebung bedeutet die Ausrüstung mit einem Temperaturkoeffizienten TK. Dies ist dann von Vorteil, wenn der natürliche Temperaturkoeffizient der Taktverschiebungsschaltung selbst bzw. derjenige der von dieser Schaltung angesteuerten Schaltung zu kompensieren ist. Ein solcher Temperaturkoeffizient läßt sich dadurch einstellen, daß man die Regelspannung $U_r$ nach Fig. 3, 5 bzw. 6 mit einem geeigneten positiven oder negativen Temperaturkoeffizienten versieht, was mit üblichen Schaltungskonzepten möglich ist. Es kann hierzu beispielsweise der Temperaturkoeffizient einer PN-Diode ausgenutzt werden.

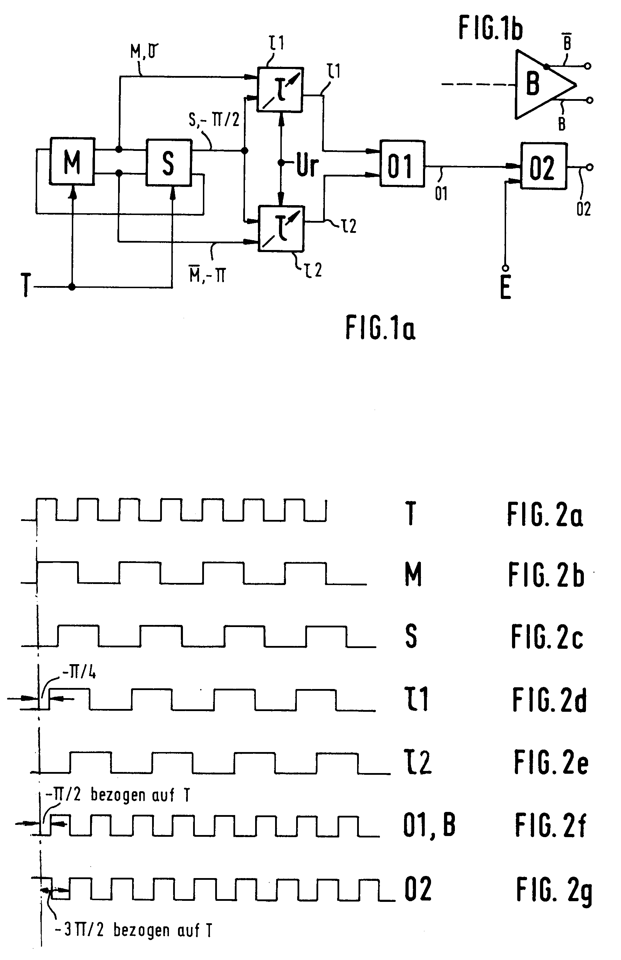

Es folgt nun die Beschreibung der Erfindung anhand der Figuren. Die Figur 1 zeigt ein Ausführungsbeispiel für eine Schaltungsanordnung zur Phasenverschiebung.

Die Figuren 2a bis 2g enthalten Impulsdiagramme über der Zeit aufgetragen für Signale an verschiedenen Punkten der Schaltung gemäß Figur 1. In Figur 3 ist das Schaltbild eines Phasenschiebers gemäß Stand der Technik wiedergegeben und in Figur 4 einige zugehörige Differenzströme über der Zeit aufgetragen.

Die Figuren 5 und 6 zeigen Schaltungsbeispiele gemäß der Erfindung und in den Figuren 7 und 8 sind einige zugehörige Spannungen und Ströme für signifikante Punkte dieser Schaltungen über der Zeit aufgetragen.

Die Erfindung geht aus von der Idee, daß ein Master-Slave-D-Flip-Flop, welches in bekannter Weise zu einem Kaskadenring verkoppelt ist, damit es als Frequenzteiler arbeitet und dann Takte der halben Frequenz mit der Phase Null, $-\pi/2$ und $-\pi$, bezogen auf die halbierte Frequenz, liefert, wenn man sowohl den Ausgang des Slaves (S) als auch den des Masters (M) verwendet. Eine solche Kaskade, welche mit dem Eingangstakt T angesteuert wird, ist in Figur 1a links erkennbar.

Der Takt T ist in der Figur 2a über der Zeit aufgetragen. Deutlich erkennbar sind die Ausgangssignale des Master-Flip-Flops M in Figur 2b mit der Phase Null und der Ausgang des Slave-Flip-Flops S mit der Phase $-\pi/2$, abgebildet in Figur 2c. Diese beiden Signale M, S werden auf die beiden Eingänge eines ersten Phasenverschiebungsgliedes üblicher Bauart $\tau 1$. s. Figur 5 auf S. 929 der eingangs zitierten Literaturstelle, gegeben (Input A und Input B). Entsprechend der eingestellten Regelspannung $U_r$(control $V_{in}$) erzeugt das Phasenschiebeglied an seinem Ausgang ($V_{out}$) ein Signal, das in dem Bereich zwischen der Phase Null und der Phase $-\pi/2$ beliebig kontinuierlich einstellbar ist. Das Ausgangssignal $\tau 1$ gemäß Figur 2d, hier wieder als Zeitdiagramm aufgetragen, weist eine Phase von ungefähr $-\pi/4$, also etwa in der Mitte des aussteuerbaren Bereichs, auf. In einem zweiten Phasenschiebeglied $\tau 2$, das von der gleichen Bauart ist und dem an seinem ersten Eingang das Slave-Signal S, also Phase $-\pi/2$, und an seinem zweiten Eingang das invertierte Master-Signal M, also die Phase $-\pi$ eingegeben werden, erzeugt an seinem Ausgang ein Signal $\tau 2$, welches je nach Regelspannung $U_r$ den Bereich von $-\pi/2$ bis $-\pi$ kontinuierlich druchfahren kann. Nun werden die beiden Phasenschieber $\tau 1$ und $\tau 2$ von derselben Regelspannung gemeinsam angesteuert, wodurch die Phasendifferenz zwischen $\tau 1$ und $\tau 2$ immer konstant auf $\pi/2$ gehalten werden kann. Das Ausgangssignal $\tau 2$ am Ausgang des zweiten Phasenschiebers ist in Figur 2e über der Zeit aufgetragen.

Die beiden Ausgangssignale der Phasenschiebeglieder $\tau 1$ und $\tau 2$ weisen immer noch die halbierte Frequenz auf. Gemäß Figur 1 wird eine anschließende Frequenzverdoppelung mit einem ausschließenden ODER-Glied 01 vorgenommen. Am Ausgang dieses EXOR-Gliedes steht nunmehr ein Signal an mit der Frequenz des eingangsseitigen Taktes T jedoch im Beispiel phasenverschoben um einen Wert von etwa $-\pi/2$ bezogen auf diese Frequenz, s. Zeitdiagramm 01 gemäß Figur 2f. Die Phase kann nun im Bereich 0 bis $-\pi$ verschoben werden. Die im mittleren Phasenschiebebereich etwas (um ca. 30 %) reduzierte Ausgangsspannung der Phasenschieber $\tau 1$ und $\tau 2$ wird i.a. durch das EXOR-Glied 01 wieder auf die binären Einheitspegel (0 bzw. 1) regeneriert. Bei Bedarf können Bufferverstärker den beiden Phasenschiebern oder dem EXOR-Glied nachgeschaltet werden (in Figur 1 nicht eingezeichnet).

Dem EXOR-Glied 01 nachgeschaltet ist ein weiteres ausschließendes ODER-Glied 02, welches an seinem zweiten Eingang E geschaltet werden kann. Wenn an diesem Eingang E der Binärwert 0 anliegt, so wird ein um 0 bis $-\pi$ phasenverschobenes Signal erzeugt, tritt aber am Eingang E der Binärwert 1 auf, so wird am Ausgang des zweiten EXOR-Gliedes ein Signal 02, s. Figur 2g, erzeugt, welches im Gegentakt verläuft, also um $-\pi$ verschoben ist. Damit aber ist der Phasenschiebebereich von Null bis $-\pi$ erweitert auf $-\pi$ bis $-2\pi$. Mit dieser Schaltungsanordnung ist also eine kontinuierliche Phasenverschiebung im Bereich von Null bis $-2\pi$ möglich. Selbstverständlich kann anstelle des zweiten EXOR-Gliedes 02 auch ein Inverter eingesetzt werden, so daß je nach Bedarf dessen Ausgangssignal oder das Ausgangssignal des EXOR-Gliedes 01 zur Weiterverarbeitung verwendet werden kann. Der Inverter kann jedoch insofern sich nachteilig auswirken, als er zusätzliche Laufzeiten aufweist, die sich bei höheren Frequenzen störend bemerkbar machen. Deshalb ist es oft günstiger, einen Buffer zu verwenden, der neben dem normalen Ausgang einen invertierenden Ausgang besitzt (s. Figur 1b) und bei dem die Signalverzögerung zwischen seinem Eingang und einem der beiden Ausgänge gleich groß ist. In diesem Fall ist auch bei hohen Frequenzen ein nahtloser Übergang zwischen den beiden Phasenbereichen 0...-$\pi$ und $-\pi$...-$2\pi$ ohne Überlappung möglich. Solche Schaltungen sind z.B. in der bekannten ECL-Schaltungstechnik üblich. Auf einen Inverter bzw. auf eine Bufferstufe mit zusätzlichem invertierendem Ausgang kann u.U. verzichtet werden, wenn das EXOR-Glied 01 - wie z.B. in der ECL-Schaltungstechnik möglich - neben dem normalen Ausgang auch einen invertierenden Ausgang besitzt.

Natürlich ist auch eine Phasenverschiebung im gesamten Bereich 0 bis $2\pi$ möglich, wenn man 2 komplette Schaltungen nach Figur 1a (Eingang T, Ausgang 01) hintereinanderschaltet und alle $2 \times 2 = 4$ Phasenschieber mit derselben Regelspannung $U_r$

ansteuert.

Eine andere Möglichkeit besteht darin, anstelle des Zweiges 01, B, 02 ein RS-Flip-Flop zu verwenden, das an seinen Set- bzw. Reset-Eingängen mit den Ausgangssignalen der beiden Phasenschiebeglieder $\tau$, $\tau2$ beaufschlagt wird und an dessen invertierten und nicht invertierten Ausgänge die gewünschten um 0 bis $-\pi$ bzw. $-\pi$ phasenverschobenen Signale abnehmbar sind.

Die Figur 3 zeigt das Grundkonzept eines einstellbaren Phasenschiebers üblicher Art.
Die Figur 4 zeigt aufgetragen über der Zeit die Differenzausgangsströme i7 minus i8 des Phasenschiebers nach Fig. 3 für verschiedene Stromaufteilungen I5 zu I6 der Einströmungen der beiden Eingangsstufen. Weiterhin aufgetragen sind ebenfalls über der Zeit die Eingangsspannungen uE1 und uE2 für die beiden Eingangsstufen und deren Ausgangsströme i1, i2 bzw. i3 und i4.
Wie weiter oben schon angedeutet, ist der in Fig. 3 wiedergegebene Phasenschieber nur zur Verschiebung sinusförmiger Taktsignale mit nicht zu großer Amplitude geeignet. Wenn die beiden Eingangsspannungen uE1 und uE2 rechteckförmig verlaufen oder die Schaltung stark übersteuert wird, werden die Verläufe der Ausgangsströme i1 bis i4 dieser beiden Stufen näherungsweise rechteckförmig. Dadurch erhält man einen Differenzausgangsstrom i7 minus i8 mit treppenförmigem Verlauf. Wegen des Zusammenhangs Ausgangsspannung uA = R1 • -(i7 - i8) wird damit auch die Ausgangsspannung uA treppenförmig. Durch die Steuerspannung $U_r$, durch die der Einspeisestrom I0 aufgeteilt wird in I5 und I6, werden die Pegel der Ausgangsspannungsstufen bestimmt. Betrachtet man die Nulldurchgänge der Eingangsspannung uE1 und der Ausgangsspannung uA, so läßt sich der Phasenwinkel $\phi$ zwischen den beiden Spannungen gemäß Figur 4 wie folgt bestimmen:

$$\phi = 0 \text{ für } U_r < 0 \text{ und } \phi = \Phi \text{ für } U_r > 0,$$

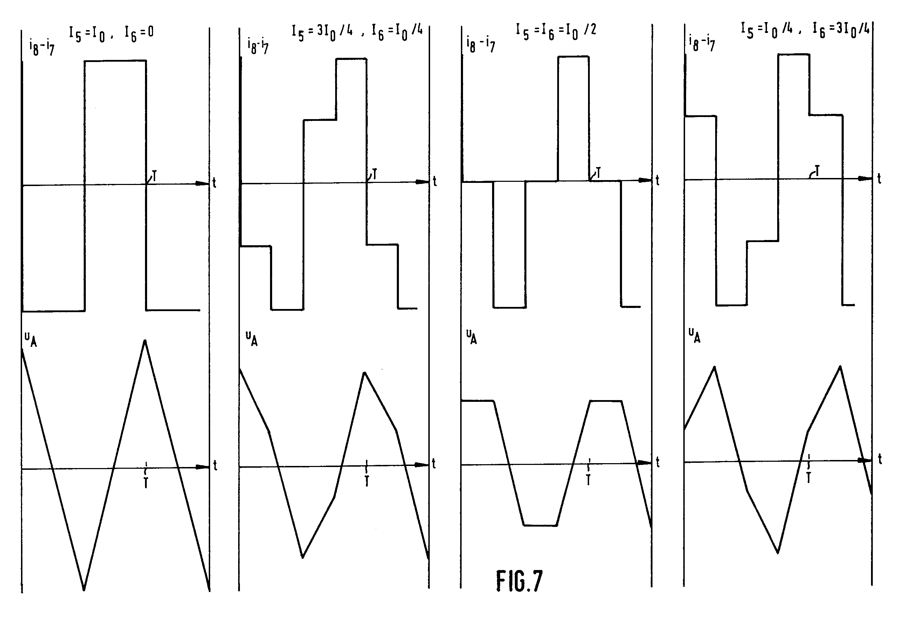

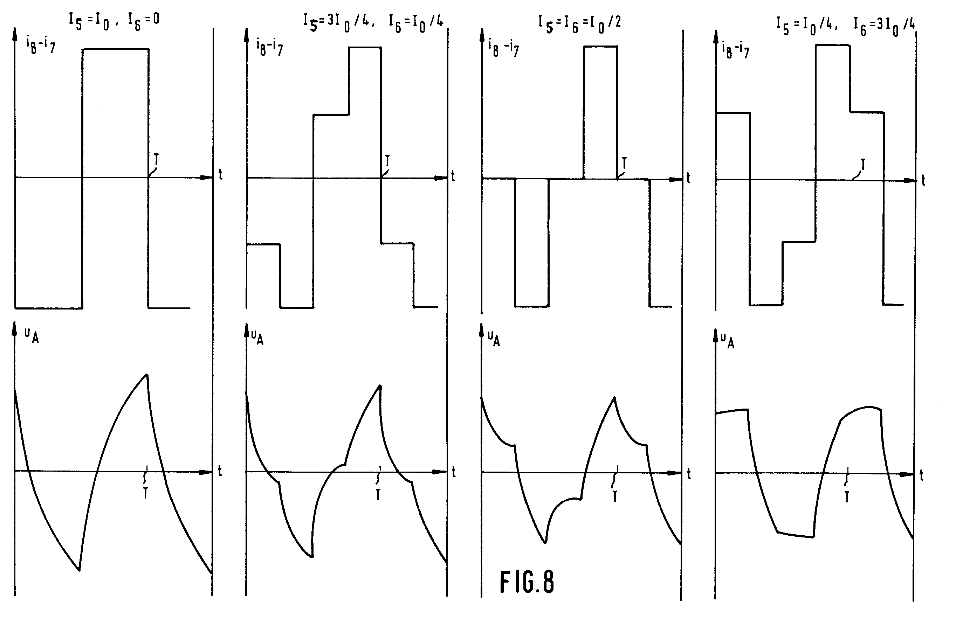

wobei $\Phi$ der Phasenwinkel zwischen uE1 und uE2 ist. Für $U_r = 0$ ist die Ausgangsspannung in bestimmten Bereichen = 0, d.h. sie besitzt keine eindeutigen Nulldurchgänge. Somit läßt sich, auch nach Regeneration des Signals, keine Phasenverschiebung zwischen Ausgangs- und Eingangsspannung des Phasenschiebers bestimmen. Für Eingangssignale mit rechteckförmigen Verlauf oder großer Amplitude ermöglicht dieses Schaltungskonzept keine kontinuierliche Phasenverschiebung. Als Komponente des in Figur 1a dargestellten Blockschaltbilds eines breitbandigen Phasenschiebers läßt sich somit die Phasenschieberschaltung gemäß Figur 3 nicht ohne weiteres und nicht unverändert einsetzen, da bei niedrigen Frequenzen die Ausgangsspannung des Master-Slave-Flip-Flops M, S rechteckförmig verlaufen. Das Konzept einer Phasenschieberschaltung, die auch bei Ansteuerung mit rechteckförmigen Signalen arbeitet, ist in Figur 5 und 6 dargestellt. Der Unterschied gegenüber der in Figur 3 dargestellten Schaltung ist der Einsatz eines Tiefpasses am Schaltungsausgang. Durch geeignete Dimensionierung der Elemente Widerstände R1 und Kondensator C1 erhält man am Schaltungsausgang vorwiegend die Grundwelle der treppenförmigen Spannung, während die Oberwellen weitgehend ausgefiltert werden. Die Kapazität C1 ist dabei die Gesamtkapazität inklusive der parasitären Kapazitäten der Transistoren T1 bis T4 der beiden Eingangsstufen und der Eingangskapazität des anschließenden EXOR-Gatters. Bei hochohmiger Dimensionierung von R1 stellt der Phasenschieberausgang einen idealen Integrator dar, dessen Ausgangsspannung in Fig. 7 für verschiedene Stromverhältnisse I5 zu I0 und I6 zu I0 skizziert ist. Eine Darstellung der Ausgangsspannung für verschiedene Stromverhältnisse I5 zu I0 und I6 zu I0 für den nichtidealen Fall, also nicht für den Grenzfall des idealen Integrators, ist in Fig. 8 wiedergegeben. Bei diesem Beispiel der Dimensionierung ist also die Kapazität C1 zu klein gewählt oder aber anders ausgedrückt die Betriebsfrequenz ist zu klein.

Eine weitere Schaltung mit einem ausgangsseitigen Tiefpaß zeigt der Phasenschieber gemäß Fig. 6, bei dem hinter dem Kondensator C1 eine Transimpedanzstufe zur Signalregeneration eingefügt ist, durch die der zulässige Frequenzbereich erweitert werden kann.

**Patentansprüche**

1. Verfahren zur Erzeugung eines um einen beliebigen einstellbaren Phasenwert zwischen Null und $-\pi$ verschobenen Taktsignales, insbesondere hoher Frequenz, unter Verwendung von üblichen kontinuierlich zwischen Null und $-\pi/2$ bzw. $-3\pi/4$ einstellbaren Phasenschiebern, wobei die Frequenz des ursprünglichen Signals (T) mittels eines Frequenzteilers halbiert wird, wobei drei gegeneinander phasenverschobene Signale (M, S, $\overline{M}$) der halben Frequenz mit den Phasenverschiebungen von 0(M), $-\pi/2$(S) und $-\pi(\overline{M})$ erzeugt werden, wobei zwei steuerbare Phasenschieber ($\tau1$, $\tau2$), mit denen jeweils ein Signal erzeugbar ist, dessen Phase kontinuierlich einstellbar ist auf einen Wert in dem Bereich zwischen der Phase eines ersten Eingangssignals und der Phase eines zweiten Eingangssignals, derart eingesetzt werden, daß der erste Phasenschieber ($\tau1$) an seinem ersten Eingang mit dem nicht verzögerten (M) und an seinem zweiten Eingang mit dem um $-\pi/2$(S) phasenverschobenen frequenzhalbier-

ten Signal gespeist wird und daß der zweite Phasenschieber ($\tau$2) an seinen beiden Eingängen mit dem um -$\pi$/2(S) phasenverschobenen bzw. mit dem um -$\pi$(M) phasenverschobenen, frequenzhalbierten Signal gespeist wird und daß sie mit derselben Steuerspannung (U$_r$) angesteuert werden und dadurch zwei um genau $\pi$/2 gegeneinander phasenverschobenen Signale mit beliebig vorgebbaren, kontinuierlichen Phasenwerten erzeugen können in den Bereichen o bis -$\pi$/2(T1) und -$\pi$/2 bis -$\pi$($\tau$2), wobei anschließend die beiden Phasenschieber-Ausgangs-Signale in einem Frequenzwerdoppler (01) so miteinander verknüpft werden, daß Phasenverschiebungswert zwischen 0 und -$\pi$ bezogen auf die Frequenz des ursprünglichen Signals (T) entstehen, und wobei die Ausgangs- und/oder Eingangssignale der beiden steuerbaren Phasenschieber ($\tau$1, $\tau$2) jeweils durch einen Tiefpaß (R$_1$,C$_1$) derart gefiltert werden, daß eventuell vorhandene Oberwellen bezüglich der halben Grundfrequenz des Takt-Signals (M, S) amplitudengedämpft werden.

2. Verfahren nach Anspruch 1, dadurch gekennzeichnet, daß als Frequenzteiler, der Phasenwerte von 0, -$\pi$/2 und -$\pi$ bezogen auf die halbierte Frequenz liefert, eine Master-Slave-D-Flip-Flop-Kaskade (M, S) verwendet wird, die durch eine invertierte Rückkopplung zu einem Ring ergänzt ist, wobei sowohl das Ausgangssignal des Slaves (S) als auch das des Masters (M) zur Ansteuerung der beiden Phasenschieber benötigt wird.

3. Verfahren nach einem der vorhergehenden Ansprüche, dadurch gekennzeichnet, daß als Frequenzverdoppler ein ausschließendes ODER-Glied (01) verwendet wird, dessen beiden Eingänge mit den Ausgangssignalen der beiden gemeinsam angesteuerten Phasenschieber (T1, T2) gespeist werden.

4. Verfahren nach Anspruch 3, dadurch gekennzeichnet, daß das Ausgangssignal des ausschließenden ODER-Gliedes zusätzlich in invertierter Form erzeugt wird.

5. Schaltungsanordnung zur Erzeugung eines um einen beliebig einstellbaren Phasenwert zwischen 0 und -$\pi$ phasenverschobenen Taktsignales, insbesondere hoher Frequenz, unter Verwendung von Phasenschiebern, mit denen jeweils ein Signal erzeugbar ist, dessen Phase kontinuierlich einstellbar ist auf einen Wert in dem Bereich zwischen der Phase eines ersten Eingangssignals und der Phase eines zweiten Eingangssignals, wobei ein durch eine invertierte Rückkopplung zu einem Ring ergänztes Master-Slave-D-Flip-Flop (M, S) als Frequenzteiler vorgesehen ist, in dessen Takteingang das zu verschiebende Signal (T) eingespeist wird und an dessen Master- und Slave-Ausgängen Signale mit den Phasenverschiebungen 0, -$\pi$/2 und -$\pi$ bezogen auf die Phase des Taktsignals erzeugt werden, wobei zwei Phasenschieber ($\tau$1, $\tau$2) vorgesehen sind, die gemeinsam durch ein Steuersignal (U$_r$) gesteuert werden, wobei die beiden Eingänge des einen Phasenschiebers ($\tau$1) mit dem unverzögerten bzw. um -$\pi$/2 verzögerten frequenzhalbierten Signal beaufschlagt sind und wobei die beiden Eingänge des anderen Phasenschiebegliedes ($\tau$2) mit dem um -$\pi$/2 bzw. um -$\pi$ verzögerten frequenzhalbierten Signal beaufschlagt sind, wobei ein ausschließendes ODER-Glied (01) vorgesehen ist, dessen Eingänge mit den Ausgängen der beiden Phasenschieber ($\tau$1, $\tau$2) verbunden sind und wobei das Ausgangssignal dieses ausschließenden ODER-Gliedes (01) das gewünschte um eine Phase im Bereich 0 bis -$\pi$ phasenverschobene Signal ist bezogen auf die Phase und Grund-Frequenz des Eingangssignals (T), wobei am Ausgang oder an den Eingängen der beiden steuerbaren Phasenschieber ($\tau$1, $\tau$2) jeweils ein Tiefpaß (R$_1$, C$_1$) eingefügt ist, durch den Oberwellen bezüglich der halben Grundfrequenz des Takt-Signals (M, S) amplitudengedämpft werden.

6. Schaltungsanordnung nach Anspruch 5, dadurch gekennzeichnet, daß dem ausschließenden ODER-Gatter (01) zwei Bufferverstärker (B) vor- bzw. ein Bufferverstärker (B) nachgeschaltet sind.

7. Schaltungsanordnung nach Anspruch 5 oder 6, dadurch gekennzeichnet, daß das ausschließende ODER-Glied (01) einen zusätzlichen, invertierenden Ausgang aufweist, an dem das um -$\pi$ bis -2$\pi$ phasenverschobene Signal abgreifbar ist.

8. Schaltungsanordnung nach Anspruch 6, dadurch gekennzeichnet, daß der nachgeschaltete Buffer (B) einen zusätzlichen, invertierenden Ausgang aufweist.

9. Schaltungsanordnung nach Anspruch 5 oder 6, dadurch gekennzeichnet, daß dem ausschließenden ODER-Glied (01) ein weiteres ausschließendes ODER-Glied (02) nachgeschaltet ist, das über seinen zweiten Eingang mit einem binären Signal (E) auf den Phasenbereich 0 bis -$\pi$ oder auf den gegenphasigen Bereich -π bis -2π schaltbar ist.

10. Schaltungsanordnung nach Anspruch 5 oder 6, dadurch gekennzeichnet, daß dem ausschließenden ODER-Glied (01) ein Inverter nachgeschaltet ist.

11. Schaltungsanordnung zur Erzeugung eines um einen beliebig einstellbaren Phasenwert zwischen 0 und -π phasenverschobenen Taktsignales, insbesondere hoher Frequenz, unter Verwendung von Phasenschiebern, mit denen jeweils ein Signal erzeugbar ist, dessen Phase kontinuierlich einstellbar ist auf einen Wert in dem Bereich zwischen der Phase eines ersten Eingangssignals und der Phase eines zweiten Eingangssignals, wobei ein durch eine invertierte Rückkopplung zu einem Ring ergänztes Master-Slave-D-Flip-Flop (M, S) als Frequenzteiler vorgesehen ist, in dessen Takteingang das zu verschiebende Signal (T) eingespeist wird und an dessen Master- und Slave-Ausgängen Signale mit den Phasenverschiebungen 0, -π/2 und -π bezogen auf die Phase des Taktsignals erzeugt werden, wobei zwei Phasenschieber (τ1, τ2) vorgesehen sind, wobei diese gemeinsam durch ein Steuersignal (U_r) ansteuerbar sind. wobei die beiden Eingänge des einen Phasenschiebers (τ1) mit dem unverzögerten bzw. um -π/2 verzögerten frequenzhalbierten Signal beaufschlagt sind und wobei die beiden Eingänge des anderen Phasenschiebers (τ2) mit dem um -π/2 bzw. um -π verzögerten frequenzhalbierten Signal beaufschlagt sind, wobei ein Reset-Set-Flip-FLop mit invertierendem Ein- und Ausgang vorgesehen ist, dessen Eingänge mit den Ausgängen der beiden Phasenschieber (τ1, τ2) verbunden sind und wobei das invertierte oder das nichtinvertierte Ausgangssignal dieses Flip-Flops das gewünschte um 0 bis -π bzw. um -π bis -2π phasenverschobene Signal ist bezogen auf die Phase und Grund-Frequenz des Eingangssignales (T), wobei am Ausgang oder an den Eingängen der beiden steuerbaren Phasenschieber (τ1, τ2) jeweils ein Tiefpaß (R_1, C_1) eingefügt ist, durch den Oberwellen bezüglich der halben Grundfrequenz des Takt-Signals (M, S) amplitudengedämpft werden.

12. Schaltungsanordnung nach einem der Ansprüche 5 bis 11, dadurch gekennzeichnet, daß die Phasenschieber mit einem Temperaturkoeffizienten versehen werden, indem jeweils an ihrem Regelspannungseingang (U_r) bekannte Temperaturgangkompensationsschaltungen, beispielsweise mit PN-Dioden, eingefügt werden.

13. Verfahren nach einem der Ansprüche 1 bis 4, dadurch gekennzeichnet, daß den Tiefpässen Verstärker nachgeschaltet sind.

14. Schaltungsanordnung nach einem der Ansprüche 5 bis 12, dadurch gekennzeichnet, daß den Tiefpässen Verstärker nachgeschaltet sind.

**Claims**

1. A method of generating a clock pulse signal, particularly a high frequency clock pulse signal, which is shifted in phase by a phase value that can be set as desired between zero and -π, by employing conventional continuous phase shifters which can be set between zero and -π/2 and -3π/4, respectively, with the frequency of the original signal (T) being divided in half by means of a frequency divider thus generating three mutually phase shifted signals (M, S, M) at one-half the frequency with phase shifts of 0(M), -π/2(S) and -π($\overline{M}$), with two controllable phase shifters (τ1, τ2) being employed which each generate a signal and are continuously adjustable in phase to a value in a range between the phase of a first input signal and the phase of a second input signal in such a manner that the first phase shifter (τ1) is fed at its first input with the undelayed signal (M) and at its second input with the frequency-halved signal shifted in phase by -π/2(S); and the second phase shifter (τ2) is fed at both its inputs with the frequency-halved signal which is shifted in phase by -π/2(S) and -π(M), respectively, both phase shifters being controlled with the same control voltage (U_r) to thus be able to generate two signals that have any desired, predeterminable, continuous phase values in a range from 0 to -π/2(τ1) and from -π/2 to -π(τ2) and are shifted in phase by precisely π/2 relative to one another; with thereafter the two phase shifted output signals being linked with one another in a frequency doubler (01) in such a way that phase shift values between 0 and -π with reference to the frequency of the original signal (T) result, and wherein the output and/or input signals of the two controllable phase shifters (τ1, τ2) are each filtered in a lowpass filter (R_1, C_1)in such a manner that possibly existing harmonics are attenuated in amplitude with respect to half the fundamental frequency of the clock pulse signal (M, S).

2. A method according to claim 1, characterised in that a master-slave D-flip-flop cascade (M, S) is employed as the frequency divider furnishing phase values of 0, $-\pi/2$ and $-\pi$ with reference to the halved frequency, said cascade being supplemented by an inverted feedback so as to form a ring, with the output signal of the slave (S) as well as that of the master (M) being required to actuate the two phase shifters.

3. A method according to one of the preceding claims, characterised in that an exclusive OR member (01) is employed as the frequency doubling member whose two inputs are fed by the output signals of the two jointly actuated phase shifters (T1, T2).

4. A method according to claim 3, characterised in that the output signal of the exclusive OR member is additionally generated in inverted form.

5. A circuit arrangement for generating a clock pulse signal, particularly a high frequency clock pulse signal, which is shifted in phase by a phase value that can be set as desired between 0 and $-\pi$ by employing phase shifters each able to generate a signal whose phase can be continuously adjusted to a value in a range between the phase of a first input signal and the phase of a second input signal, with a master-slave D-flip-flop (M, S) supplemented by an inverted feedback so as to form a ring being provided as the frequency divider to whose clock pulse input the signal (T) to be shifted is fed and whose master and slave outputs generate signals with phase shifts of 0, $-\pi/2$ and $-\pi$ with respect to the phase of the clock pulse signal, with two phase shifters ($\tau$1, $\tau$2) being provided which are controlled jointly by a control signal ($U_r$); the two inputs of the one phase shifter ($\tau$1) are charged by the undelayed frequency-halved signal and by the frequency-halved signal delayed by $-\pi/2$, respectively, and the two inputs of the other phase shifting member ($\tau$2) are charged by the frequency-halved signal delayed by $-\pi/2$ and $-\pi$, respectively; an exclusive OR member (01) is provided whose inputs are connected with the outputs of the two phase shifters ($\tau$1, $\tau$2) and the output signal of said exclusive OR member (01) is the desired signal which is shifted in phase by a phase within a range from 0 to $-\pi$ with reference to the phase and fundamental frequency of the input signal (T), wherein a lowpass filter ($R_1$, $C_1$) is included at each of the outputs or inputs of the two controllable phase shifters ($\tau$1, $\tau$2) so as to attenuate the amplitude of the harmonics with respect to half the fundamental frequency of the clock pulse signal (M, S).

6. A circuit arrangement according to claim 5, characterised in that two buffer amplifiers (B) are connected to the input of the exclusive OR gate (01) and one buffer amplifier (B) is connected to its output.

7. A circuit arrangement according to claim 5 or 6, characterised in that the exclusive OR member (01) has an additional, inverting output at which the signal shifted in phase by $-\pi$ to $-2\pi$ can be obtained.

8. A circuit arrangement according to claim 6, characterised in that the subsequently connected buffer (B) has an additional inverting output.

9. A circuit arrangement according to claim 5 or 6, characterised in that a further exclusive OR member (02) is connected to the output of the exclusive OR member (01) and can be switched by way of its second input and by means of a binary signal (E) to the phase range from 0 to $-\pi$ or to the opposite phase range from $-\pi$ to $-2\pi$.

10. A circuit arrangement according to claim 5 or 6, characterised in that an inverter is connected to the output of the exclusive OR member (01).

11. A circuit arrangement for generating a clock pulse signal, particularly a high frequency clock pulse signal, which is shifted in phase by a phase value that can be set as desired between 0 and $-\pi$ by employing phase shifters each able to generate a signal whose phase can be continuously adjusted to a value in a range between the phase of a first input signal and the phase of a second input signal, with a master-slave D-flip-flop (M, S) supplemented by an inverted feedback so as to form a ring being provided as the frequency divider to whose clock pulse input the signal (T) to be shifted is fed and whose master and slave outputs generate signals with phase shifts of 0, $-\pi/2$ and $-\pi$ with respect to the phase of the clock pulse signal; with two phase shifters ($\tau$1, $\tau$2) being provided; said phase shifters are controlled jointly by a control signal ($U_r$); the two inputs of the one phase shifter ($\tau$1) are charged by the undelayed frequency-halved signal and by the frequency-halved signal delayed by $-\pi2$, respectively, and the two inputs of the other phase shifter ($\tau$2) are charged by the frequency-halved signal delayed by $-\pi/2$

and -$\pi$, respectively; a reset flip-flop (RS) is provided which has an inverting input and an inverting output, whose inputs are connected with the outputs of the two phase shifters ($\tau$1, $\tau$2) and the inverted or the non-inverted output signal of said flip-flop is the desired signal which is shifted in phase by 0 to -$\pi$ and by -$\pi$ to -2$\pi$, respectively, with reference to the phase and the fundamental frequency of the input signal (T), wherein a lowpass filter ($R_1$, $C_1$) is included at each of the outputs or inputs of the two controllable phase shifters ($\tau$1, $\tau$2) so as to attenuate the amplitude of the harmonics with respect to half the fundamental frequency of the clock pulse signal (M, S).

12. A circuit arrangement according to one of claims 5 to 11, characterised in that the phase shifters are provided with a temperature coefficient in that known temperature response compensation circuits, for example those including PN diodes, are inserted at their control voltage inputs ($U_r$).

13. A method according to one of claims 1 to 4, characterised in that amplifiers are connected to the outputs of the lowpass filters.

14. A circuit arrangement according to one of claims 5 to 12, characterised in that amplifiers are connected to the outputs of the lowpass filters.

**Revendications**

1. Procédé pour produire un signal d'horloge déplacé d'une valeur de phase quelconque, réglable, entre zéro et -$\pi$, en particulier un signal d'horloge de haute fréquence, en utilisant des déphaseurs habituels, réglables de façon continue entre zéro et -$\pi$/2 ou -3$\pi$/4, procédé selon lequel la fréquence du signal original (T) est divisée par deux au moyen d'un diviseur de fréquence, selon lequel trois signaux (M, S, $\overline{M}$) mutuellement déphasés, ayant la moitié de la fréquence, sont produits avec les déphasages 0(M), -$\pi$/2(S) et -$\pi$($\overline{M}$), selon lequel deux déphaseurs commandés ($\tau$1, $\tau$2), par chacun desquels peut être produit un signal dont la phase est réglable de façon continue sur une valeur dans le domaine compris entre la phase d'un premier signal d'entrée et la phase d'un second signal d'entrée, sont utilisés de manière que le premier déphaseur ($\tau$1) soit alimenté à sa première entrée par le signal de fréquence divisée par deux qui n'est pas retardé (M) et à sa seconde entrée par le signal de fréquence divisée par deux qui est déphasé de

-$\pi$/2(S), et que le second déphaseur ($\tau$2) soit alimenté à ses deux entrées respectivement par le signal de fréquence divisée par deux qui est déphasé de -$\pi$/2(S) et par le signal de fréquence divisée par deux qui est déphasé de -$\pi$(M), et de manière qu'ils soient pilotés par la même tension de commande ($U_r$) et puissent ainsi produire deux signaux mutuellement déphasés d'exactement $\pi$/2 et ayant des valeurs de phase continues pouvant être préfixées selon les désirs dans les domaines 0 à -$\pi$/2($\tau$1) et -$\pi$/2 à -$\pi$t($\tau$2), selon lequel, ensuite, les deux signaux de sortie des déphaseurs sont combinés ensemble, dans un doubleur de fréquence (01), de manière que des valeurs de déplacement de phase entre 0 et -$\pi$ soient établies par rapport à la fréquence du signal original (T), et selon lequel les signaux de sortie et/ou d'entrée des deux déphaseurs commandés ($\tau$1, $\tau$2) sont filtrés chaque fois par un filtre passe-bas ($R_1$, $C_1$), de manière que des harmoniques éventuellement présents, par rapport à la demi-fréquence fondamentale du signal d'horloge (M, S), soit atténués en amplitude.

2. Procédé selon la revendication 1, caractérisé en ce que, comme diviseur de fréquence, fournissant des valeurs de phase de 0, -$\pi$/2 et -$\pi$ par rapport à la fréquence divisée par deux, on utilise une bascule maître-esclave de type D en cascade (M, S) qui est complétée par un contrecouplage inversé en un anneau, le pilotage des deux déphaseurs demandant à la fois le signal de sortie de l'esclave (S) et le signal de sortie du maître (M).

3. Procédé selon une des revendications précédentes, caractérisé en ce que, comme doubleur de fréquence, on utilise un élément OU exclusif (01) dont les deux entrées sont alimentées avec les signaux de sortie des deux déphaseurs ($\tau$1, $\tau$2) pilotés en commun.

4. Procédé selon la revendication 3, caractérisé en ce que le signal de sortie de l'élément OU exclusif est produit en plus sous sa forme inversée.

5. Circuit pour produire un signal d'horloge, en particulier de haute fréquence, qui est déphasé d'une valeur de phase réglable à volonté entre 0 et -$\pi$, avec utilisation de déphaseurs permettant chacun de produire un signal dont la phase est réglable de façon continue à une valeur dans le domaine compris entre la phase d'un premier signal d'entrée et la phase d'un second signal d'entrée, circuit dans lequel une bascule maître-esclave de type D (M, S), complétée par un rétrocouplage inversé en un anneau, est prévue comme diviseur de fréquence, bascule dans l'entrée d'horloge de laquelle est injecté le signal (T) à déplacer et aux sorties de maître et d'esclave de laquelle sont produits des signaux ayant les déphasages 0, $-\pi/2$ et $-\pi$ par rapport à la phase du signal d'horloge, dans lequel sont prévus deux déphaseurs ($\tau 1$, $\tau 2$) pilotés en commun par un signal de commande ($U_r$), les deux entrées d'un déphaseur ($\tau 1$) recevant respectivement le signal de fréquence divisée par deux qui n'est pas retardé et le signal de fréquence divisée par deux qui est retardé de $-\pi/2$ et les deux entrées de l'autre déphaseur ($\tau 2$) recevant respectivement le signal de fréquence divisée par deux qui est retardé de $-\pi/2$ et le signal de fréquence divisée par deux qui est retardé de $-\pi$, dans lequel est prévu un élément OU exclusif (01) dont les entrées sont reliées aux sorties des deux déphaseurs ($\tau 1$, $\tau 2$) et dans lequel le signal de sortie de cet élément OU exclusif (01) est le signal désiré, déphasé d'une valeur de phase comprise dans le domaine 0 à $-\pi$, par rapport à la phase et à la fréquence fondamentale du signal d'entrée (T), et dans lequel un filtre passe-bas ($R_1$, $C_1$) est intercalé chaque fois à la sortie ou aux entrées des deux déphaseurs commandés ($\tau 1$, $\tau 2$), filtre passe-bas par lequel sont atténués en amplitude les harmoniques par rapport à la demi-fréquence fondamentale du signal d'horloge (M, S).

6. Circuit selon la revendication 5, caractérisé en ce que la porte OU exclusif (01) est précédée de deux amplificateurs tampons (B) et suivie d'un amplificateur tampon (B).

7. Circuit selon la revendication 5 ou 6, caractérisé en ce que l'élément OU exclusif (01) présente une sortie supplémentaire, inverseuse, sur laquelle peut être prélevé le signal déphasé de $-\pi$ à $-2\pi$.

8. Circuit selon la revendication 6, caractérisé en ce que le tampon (B) monté à la suite de la porte, présente une sortie supplémentaire inverseuse.

9. Circuit selon la revendications 5 ou 6, caractérisé en ce que l'élément OU exclusif (01) est suivi d'un autre élément OU exclusif (02) qui peut être commuté sur le domaine de phase de 0 a $-\pi$ ou sur le domaine de phase opposé de $-\pi$ à $-2\pi$ par un signal binaire (E) appliqué à sa seconde entrée.

10. Circuit selon la revendication 5 ou 6, caractérisé en ce que l'élément OU exclusif (01) est suivi d'un inverseur.

11. Circuit pour produire un signal d'horloge, en particulier de haute fréquence, qui est déphasé d'une valeur de phase réglable à volonté entre 0 et $-\pi$, avec utilisation de déphaseurs permettant chacun de produire un signal dont la phase est réglable de façon continue à une valeur dans le domaine compris entre la phase d'un premier signal d'entrée et la phase d'un second signal d'entrée, circuit dans lequel une bascule maître-esclave de type D (M, S), complétée par un rétrocouplage inversé en un anneau, est prévue comme diviseur de fréquence, bascule dans l'entrée d'horloge de laquelle est injecté le signal (T) à déplacer et aux sorties de maître et d'esclave de laquelle sont produits des signaux ayant les déphasages 0, $-\pi/2$ et $-\pi$ par rapport à la phase du signal d'horloge, dans lequel sont prévus deux déphaseurs ($\tau 1$, $\tau 2$) pilotés en commun par un signal de commande ($U_r$), les deux entrées d'un déphaseur ($\tau 1$) recevant respectivement le signal de fréquence divisée par deux qui n'est pas retardé et le signal de fréquence divisée par deux qui est retardé de $-\pi/2$ et les deux entrées de l'autre déphaseur ($\tau 2$) recevant respectivement le signal de fréquence divisée par deux qui est retardé de $-\pi/2$ et le signal de fréquence divisée par deux qui est retardé de $-\pi$, dans lequel est prévue une bascule à remise à 0 et mise à 1, avec une entrée et une sortie inverseuses, dont les entrées sont reliées aux sorties des deux déphaseurs ($\tau 1$, $\tau 2$) et dans lequel le signal de sortie inversé ou non-inversé de cette bascule est le signal désiré, déphasé de 0 à $-\pi$ ou de $-\pi$ à $-2\pi$, par rapport à la phase et la fréquence fondamentale du signal d'entrée (T), et dans lequel un filtre passe-bas ($R_1$, $C_1$) est intercalé chaque fois à la sortie ou aux entrées des deux déphaseurs commandés ($\tau 1$, $\tau 2$), filtre passe-bas par lequel sont atténués en amplitude les harmoniques par rapport à la demi-fréquence fondamentale du signal d'horloge (M, S).

12. Circuit selon une des revendications 5 à 11, caractérisé en ce que les déphaseurs sont pourvus d'un coefficient de température par l'interposition, dans leurs entrées de tension de réglage ($U_r$) respectives, de circuits connus de compensation des variations de température, comportant des diodes PN par exemple.

**13.** Procédé selon une des revendications 1 à 4, caractérisé en ce que les filtres passe-bas sont suivis d'amplificateurs.

**14.** Circuit selon une des revendications 5 à 12, caractérisé en ce que les filtres passe-bas sont suivis d'amplificateurs.

FIG.1b

FIG.1a

FIG. 2a — T

FIG. 2b — M

FIG. 2c — S

FIG. 2d — T1

−π/4

FIG. 2e — T2

−π/2 bezogen auf T

FIG. 2f — 01, B

FIG. 2g — 02

−3π/2 bezogen auf T

FIG.3

FIG.6

EP 0 349 715 B1

$I_5 = I_0, \quad I_6 = 0$

$I_5 = 3I_0/4, \quad I_6 = I_0/4$

$I_5 = I_6 = I_0/2$

$I_5 = I_0/4, \quad I_6 = 3I_0/4$

$u_{E1}$   $t$

$u_{E2}$   $t$

$i_1$   $t$

$i_2$   $t$

$i_3$   $t$

$i_4$   $t$

$i_7 - i_8$   $t$

FIG.4

FIG. 5

FIG.7

FIG.8